(19)

Europäisches
Patentamt
European
Patent Office
Office européen
des brevets

(11) **EP 1 643 653 B1**

(12) **EUROPEAN PATENT SPECIFICATION**

(45) Date of publication and mention
of the grant of the patent:
**21.01.2009 Bulletin 2009/04**

(51) Int Cl.:
***H03M 13/11*** *(2006.01)*

(21) Application number: **04255958.3**

(22) Date of filing: **29.09.2004**

(54) **Iterative decoding of low-density parity-check (LDPC) codes**

Iterative Decodierung von Low-Density Parity-Check (LDPC) Codes

Décodage itératif des codes LDPC

(84) Designated Contracting States:
**DE FR GB**

(43) Date of publication of application:
**05.04.2006 Bulletin 2006/14**

(73) Proprietor: **LUCENT TECHNOLOGIES INC.**
**Murray Hill NJ 07974-0636 (US)**

(72) Inventors:
• **Benet, Raul**
**08330 Premia de Mar (ES)**
• **de Lind van Wijngaarden, Adriaan**
**Union**
**NJ 07974 (US)**
• **Dohmen, Ralf**
**78050 VS-Villingen (DE)**
• **Richardson, Thomas**
**Essex**
**NJ 07079 (US)**
• **Urbanke, Rudiger**
**Lausanne (CH)**

(74) Representative: **Sarup, David Alexander et al**
**Alcatel-Lucent Telecom Limited**
**Unit 18, Core 3, Workzone**
**Innova Business Park**
**Electric Avenue**
**Enfield**
**EN3 7XU (GB)**

(56) References cited:
**US-A1- 2004 148 561**

• **KOU Y ET AL: "Low-density parity-check codes based on finite geometries: A rediscovery and new results" IEEE TRANSACTIONS ON INFORMATION THEORY, IEEE INC. NEW YORK, US, vol. 47, no. 7, November 2001 (2001-11), pages 2711-2736, XP002275913 ISSN: 0018-9448**
• **GALLAGER R. G.: "Low-density parity-check codes" IRE TRANSACTIONS ON INFORMATION THEORY, IEEE INC. NEW YORK, US, January 1962 (1962-01), pages 21-28, XP000992693**
• **RICHARDSON T ET AL: "The renaissance of Gallager's low-density parity-check codes" IEEE COMMUNICATIONS MAGAZINE, IEEE SERVICE CENTER. PISCATAWAY, N.J, US, vol. 41, no. 8, August 2003 (2003-08), pages 126-131, XP001177711 ISSN: 0163-6804**

**Description**

## Field of the Invention

This invention relates to forward error correcting codes and to decoders that effectively retrieve and restore the encoded information through the use of such codes.

## Art Background

In modem technologies related to high-speed digital communication, as well as those related to the reproduction of recorded audio, video, or other data, it is often desirable to restore information that has been corrupted due to signal degradation in transmission, or due to damage suffered by the recording medium. Various methods have been used to encode signals with redundant information included in the encoded bit stream. At the receiver, the redundant information can be used in appropriate algorithms for correcting errors in the received signal. Such methods, which do not require any feedback from the receiver to the transmitter, are referred to as channel coding or "forward error control" (FEC) coding.

In high-speed optical communications, for example, it has proved useful to employ algebraic codes such as BCH codes and Reed-Solomon codes for forward error correction. These codes correct, for a given length n and dimension $k$, a predefined number of errors, $e$. The encoding and decoding complexity increases significantly with increasing block length $n$ and redundancy $(n-k)$.

Although such codes are useful, there has been a need for alternative FEC codes, which are highly effective in correcting errors and have a low encoding and decoding complexity.

One useful alternative to algebraic codes is provided by so-called low-density parity-check (LDPC) codes. LDPC codes are defined by a set of binary parity-check equations. An LDPC code of length $n$ and $r$ parity-check equations can be specified as the set of all binary vectors x of length $n$ that fulfill a linear algebraic equation $\mathbf{H} x = 0$, where $\mathbf{H}$ is a $r \times n$ binary matrix with entries $h_{i,j}$ and 0 denotes the null-vector of length $r$. This matrix has the property that it has a low density of ones. Each row corresponds to a grouping of selected bits of the data word, together with selected check bits, and it has the property that the sum of the values of the bits associated by each grouping is 0 modulo 2.

Systematic LDPC codes are a type of FEC codes in which the codeword is formed by appending check bits to the "data word," i.e., to the sequence of bits representing the original data prior to coding, and the values of the check bits are adjusted so that the sum of the bits associated by each grouping is 0 modulo 2. Systematic codes have the property that the bits of the data word are not modified and can be extracted directly from the codeword.

In the decoders for LDPC codes that have hitherto been known, data and check bits of the received codeword are held in a register. In each of potentially many iterations, the values of these bits are updated in accordance with the results of a parity check. After some number of iterations, this process tends to converge to a state in which the positions in the register that correspond to uncorrupted bits are storing the as-received values of those bits, whereas those positions that correspond to corrupted bits are storing the complements of the as-received values.

Although such decoders are useful, they could be made even more attractive by reducing their power requirements. The amount of power that is needed for a calculation in an Application Specific Integrated Circuit (ASIC) is typically directly related to the switching activity inside the circuit. Complementary Metal Oxide Semiconductor (CMOS) technologies and Bipolar CMOS (BiCMOS) technologies, commonly used for ASICs, draw a significant power supply current during logic transitions, and a negligibly small leakage current otherwise. This is an attractive low-power feature that can be exploited by minimizing the switching activity inside the circuit.

In the art, Kou, "Low-Density Parity-Check Codes Based On Finite Geometries: A Rediscover And New Results," IEEE Transactions On Information Theory, Vol. 47, No. 7, November 2001, pp. 2711-2736 provides a general teaching of LDPC coding, including decoders arranged to implement a bit-flipping update process.

## Summary of the Invention

A method and apparatus according to the present invention arc set out in the independent claims, to which the reader is now referred. Preferred features are laid out in the dependent claims.

We have developed an LDPC decoder that has reduced power requirements. After an initial parity check, our decoder holds in a register 0-values for those bits of the received codeword that satisfy a parity check, and 1-values for those bits that fail the parity check. In subsequent iterations, updates are performed on the bits in this parity register rather than directly on the data bits. Because most bits will, in fact, be received without corruption, the register will be populated mostly with 0-values and the switching activity will be low. As a consequence, power requirements will be reduced.

**Brief Description of the Drawing**

FIG. 1 is a graphical representation of an example LDPC code.
FIG. 2 is a flowchart of a procedure according to the present invention in an exemplary embodiment.

**Detailed Description**

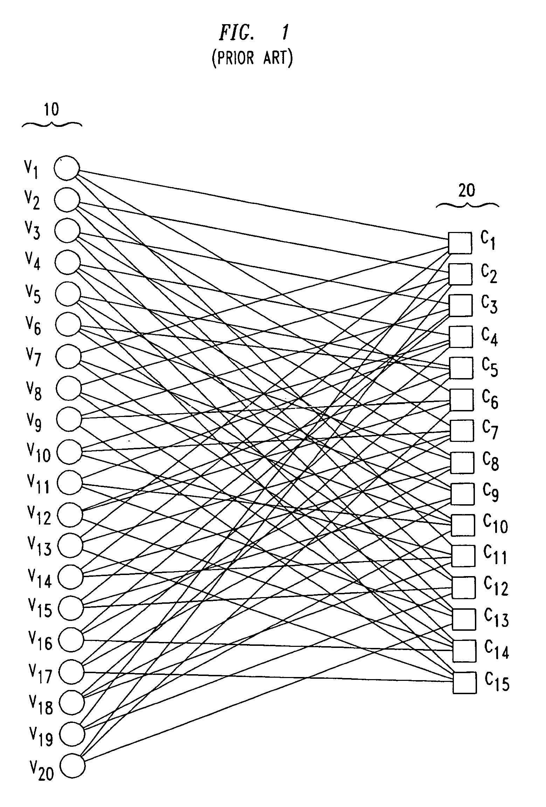

FIG. 1 illustrates a (3,4) regular LDPC code of length 20 that is defined by the matrix

$$
\mathbf{H} =
\begin{bmatrix}
1 & 0 & 0 & 0 & 0 & 0 & 1 & 0 & 0 & 0 & 0 & 0 & 1 & 0 & 0 & 0 & 0 & 0 & 1 & 0 \\
0 & 1 & 0 & 0 & 0 & 0 & 0 & 1 & 0 & 0 & 0 & 0 & 0 & 1 & 0 & 0 & 0 & 0 & 0 & 1 \\
0 & 0 & 1 & 0 & 0 & 0 & 0 & 0 & 1 & 0 & 0 & 0 & 0 & 0 & 1 & 1 & 0 & 0 & 0 & 0 \\
0 & 0 & 0 & 1 & 0 & 0 & 0 & 0 & 0 & 1 & 1 & 0 & 0 & 0 & 0 & 0 & 1 & 0 & 0 & 0 \\
0 & 0 & 0 & 0 & 1 & 1 & 0 & 0 & 0 & 0 & 0 & 1 & 0 & 0 & 0 & 0 & 0 & 1 & 0 & 0 \\
1 & 0 & 0 & 0 & 0 & 0 & 0 & 0 & 1 & 0 & 0 & 1 & 0 & 0 & 0 & 0 & 0 & 0 & 0 & 1 \\
0 & 1 & 0 & 0 & 0 & 0 & 0 & 0 & 0 & 1 & 0 & 0 & 1 & 0 & 0 & 1 & 0 & 0 & 0 & 0 \\
0 & 0 & 1 & 0 & 0 & 1 & 0 & 0 & 0 & 0 & 0 & 0 & 0 & 1 & 0 & 0 & 1 & 0 & 0 & 0 \\
0 & 0 & 0 & 1 & 0 & 0 & 1 & 0 & 0 & 0 & 0 & 0 & 0 & 0 & 1 & 0 & 0 & 1 & 0 & 0 \\
0 & 0 & 0 & 0 & 1 & 0 & 0 & 1 & 0 & 0 & 1 & 0 & 0 & 0 & 0 & 0 & 0 & 0 & 1 & 0 \\
1 & 0 & 0 & 0 & 0 & 0 & 0 & 0 & 0 & 1 & 0 & 0 & 0 & 1 & 0 & 0 & 0 & 1 & 0 & 0 \\
0 & 1 & 0 & 0 & 0 & 1 & 0 & 0 & 0 & 0 & 0 & 0 & 0 & 0 & 1 & 0 & 0 & 0 & 1 & 0 \\
0 & 0 & 1 & 0 & 0 & 0 & 1 & 0 & 0 & 0 & 1 & 0 & 0 & 0 & 0 & 0 & 0 & 0 & 0 & 1 \\
0 & 0 & 0 & 1 & 0 & 0 & 0 & 1 & 0 & 0 & 0 & 1 & 0 & 0 & 0 & 1 & 0 & 0 & 0 & 0 \\
0 & 0 & 0 & 0 & 1 & 0 & 0 & 0 & 1 & 0 & 0 & 0 & 1 & 0 & 0 & 0 & 1 & 0 & 0 & 0
\end{bmatrix}
$$

That is, every codeword of this LDPC code is twenty bits long, and each bit of the codeword must satisfy three parity conditions, which in this example are linear constraints. Each of the linear constraints involves four bits of the codeword.

FIG. 1 represents the code in terms of a bipartite graph consisting of nodes interconnected by edges. Nodes $V = V_1 \ldots V_{20}$, which belong to array 10, are referred to as "variable nodes." These values may be stored in, e.g., a register. Initially, each node is associated with the binary value of a corresponding bit of the received word $R = R_1 \ldots R_n$. Nodes $C = C_1 \ldots C_{15}$, which belong to array 20, are referred to as "check nodes." Associated with each check node is the sum, modulo 2, of all variable nodes that are its neighbors; that is, of all variable nodes that are connected to it by an edge, i.e., $C = \mathbf{H}V^T$. The binary values associated with the check nodes may be stored, e.g., in a register. It will be seen that because the code is (3, 4) regular, every variable node has degree 3 and every check node has degree 4.

To illustrate the decoding procedure, consider the situation where the received word $R$ is 00000111111111100000. The first step is to assign $R$ to $V$. Next, the check nodes $C$ are computed. It will be seen that all of the parity sums in array 20 have the value 0. Thus, the codeword represented by array 10 satisfies the parity condition. Hence, in this case $C = \mathbf{H}V^T = 0$. The decoding process is complete and the decoded word $Z = V$ is a valid codeword.

The operation of the decoder is now explained for the situation where the received word $R$ is 00000111111011100000. This example may represent the situation in which a codeword has been received with an error at bit 12. That is, when compared to the previous example, the bit at node $V_{12}$ has been changed from 1 to 0. As a consequence, the parity sums at nodes $C_5$, $C_6$, and $C_{14}$ have changed from 0 to 1.

In accordance with the operation of the decoder, the parity check bits are passed from each check node back to its neighboring variable nodes. At each variable node $i$, the incoming parity sums are added and compared with a threshold value $T_i^{(t)}$, where $t$ indicates the iteration number. Let $S = (S_1, \ldots, S_n)$ denote the parity sums for each variable

node, such that $S_i$, where $1 \leq i \leq n$,. represents the result, at each respective variable node, of adding up the parity sums that have been passed back. For this example, $S$ is (1,0,0,1,1,1,0,1,1,0,0,3,0,0,0,1,0,1,0,1). The respective values of $C$, $S$ and $V$ are specified for each iteration in Table 1.

**Table 1**

| $t$ | $T^{(t)}$ | $C= C_1...C_r$ | $S=(S_1,...,S_r)$ | $V = V_1...V_n$ |
|---|---|---|---|---|
| 0 | - | | | 00000111111011100000 |
| 1 | 3 | 000011000000010 | (1,0,0,1,1,1,0,1,1,0,0,3,0,0,0,1,0,1,0,1) | 00000111111111100000 |
| 2 | 3 | 000000000000000 | (0,0,0,0,0,0,0,0,0,0,0,0,0,0,0,0,0,0,0,0) | 00000111111111100000 |

It follows that the total stored at node $S_{12}$ is 3, whereas the totals stored at all other variable nodes are less. A threshold test is applied to the total stored at each node, using, e.g., a comparator circuit adjusted to an appropriate threshold. If the total stored at any variable node equals or exceeds the threshold, the bit stored at the corresponding position in array 10 is replaced by its binary complement. Thus, if the threshold in the present example is set at 3 for all nodes, the bits of the codeword at variable nodes 1-11 and 13-20 will be unchanged, but the bit at node 12 will be reversed. The next step is to determine the parity check sums for the updated values at the variable nodes. It can be verified that in this example the parity sums $C_1...C_r$ are equal to the all-zero vector and therefore the variable nodes $V_1...V_n$ now contain a valid codeword.

In general, the process described above will be iterated. Different thresholds may be used for different variable nodes and for different iterations. It is generally beneficial for the threshold to slightly vary with increasing iteration number. The thresholds may be pre-set or adaptive. After each iteration, the variable node bits, as represented in array 10, are updated. The procedure continues until the parity-sums $C_1...C_r$ become equal to the all-zero vector, after which the sequence stored in the variable nodes $V_1...V_n$, a valid codeword, are output. If the parity-sums are not satisfied after a certain maximum number of iterations, the decoder stops and typically outputs the received word to avoid introducing extra errors.

We have found that a modification of the above procedure is useful for reducing power consumption in the digital processing device in which information in the array of variable nodes 10 and the array of check nodes 20 is stored.

According to our modified procedure, array 10 is, as before, an actively updated array of variable nodes, which initially stores the received word. However, the functionality of these nodes changes during the first iteration. After the first and every subsequent iteration, the array 10 instead stores a flip indicator for each respective bit of the codeword. Accordingly, array 10 will in this context be referred to as the "flip-indicator" array, which can actually be stored at the same memory locations as the variable node array $V$.

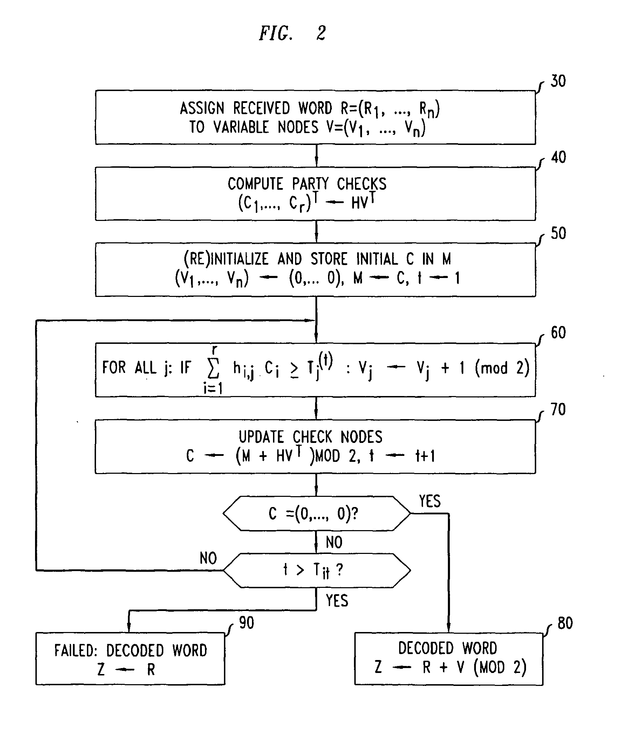

The modified procedure will now be described in further detail with reference to FIG. 2. At block 30 of FIG. 2, the array of variable nodes 10 (as seen in FIG. 1) are loaded with the bits of the received word $R$, as described above. At block 40, parity sums $C = \mathbf{H}V^T$ are computed at the check nodes, as described above.

At this point, the procedure takes on certain modified features. Array 10, which will hereafter function as a flip-indicator array, is initialized to contain all zero entries, as indicated at block 50 of FIG. 2. In addition, the computed values of the check nodes $C_1...C_r$ are stored in an array $M =M_1..M_r$.

Then, as indicated at block 60, the sums

$$S_j = \sum_{i=1}^{r} h_{i,j}C_i$$

are determined by ordinary and not by modular arithmetic. Each sum $S_j$ is subjected to a threshold test as described above. If the sum $S_j$ is greater or equal than the threshold $T_j^{(t)}$, the flip-indicator value $V_j$ is inverted, i.e., $V_j$ is updated according to $V_j \leftarrow V_j \oplus 1$, wherein the symbol $\oplus$ denotes the exclusive-or (XOR) operation, which is equivalent to $V_j \leftarrow V_j + 1$ modulo-two addition.

Then, as indicated at block 70, each check node $C_1...C_r$ is updated by adding to its initial value $M_i$, via an XOR operation, the new values $V_1...V_n$ sent to it by each variable node in the neighborhood of $C_i$. The resulting sum at each check node constitutes a new parity sum. If the parity checks $C_1...C_r$ are identical to the all-zero vector, the decoding operation is complete and the decoded word $Z$ is, as indicated in block 80, equal to $R \oplus V$. Otherwise, control then returns to block 60, where the sums $S_j$ are recomputed and the variable nodes $V_1...V_n$ are updated subject to the threshold test.

The procedure continues until the parity checks $C_1...C_r$ become equal to the all-zero vector or the number of iterations $t$ exceeds a predefined value $T_{it}$. If the latter is the case, and $C_1...C_r$ is not the all-zero vector, the result of the decoding process is inconclusive and the decoder has not been able to find a valid codeword. It then typically outputs, as indicated in block 90, the received word $R$ to avoid the insertion of decoding errors.

As an example that illustrates the decoding process, we introduce the codeword $Y$=1010100111100111110. Assume that during transmission, three errors occur at, respectively, positions 2, 5, and 15 of the codeword. Thus, the received word $R$ will have the form $R$ =11100001111001010110 . We decode using a threshold scheme ($T^{(1)}$, $T^{(2)}$, $T^{(3)}$, $T^{(4)}$, $T^{(5)}$) = (3, 2, 3, 3, 3) , where $T_j^{(t)} = T^{(t)}$ for every variable node $j$ . The parity-check vector $C$ takes the values 011010101100001. At the variable nodes, we obtain the sum vector $S$ = (0,2,1,1,3,1,1,2,2,1,1,1,2,1,2,2,1,2,1,1). Applying the first threshold $T^{(1)} = 3$ , we obtain the flip-indicator vector $V$ = 00001000000000000000 . In subsequent iterations in which the respective thresholds are applied, we obtain the vectors at the variable nodes and the corresponding flip-indicator vectors listed in Table 2.

**Table 2**

| $t$ | $T^{(t)}$ | $C = C_1...C_r$ | $S = (S_1,..., S_r)$ | $V = V_1...V_n$ |
|---|---|---|---|---|
| 1 | 3 | 011010101100001 | (0,2,1,1,3,1,1,2,2,1,1,1,2,1,2,2,1,2,1,1) | 00001000000000000000 |
| 2 | 2 | 011000101000000 | (0,2,1,1,0,0,1,1,1,1,0,0,1,1,2,2,0,1,0,1) | 01001000000000110000 |
| 3 | 3 | 001000100000010 | (0,1,1,1,0,0,0,1,1,1,0,1,1,0,1,3,0,0,0,0) | 01001000000000100000 |

It can be easily verified that convergence is reached after three iterations, because at the end of the third iteration, the check node vector will be the all-zero vector. It is therefore not necessary to perform further iterations.

Note that one could as well perform the test for an all-zero vector just before the operation in block 60 instead of just after block 70 (as shown in FIG. 2).

It should be noted that the particular flow depicted in FIG. 1 serves only as an example to illustrate the new method.

For pedagogical purposes, the example given above has involved a relatively short code. In general, the longer the code, the better will be the performance of the decoder. In practice, code lengths may be as high as 30,000 or even more. However, in contrast to conventional approaches, in our approach the power consumption depends mainly on the error fraction and not directly on the data that is transmitted. As a consequence, very great efficiencies are achieved in high rate codes and in long codes when error rates are relatively low.

**Claims**

1. A decoding method, comprising:

    a) performing a parity check (40) on the bits of a received word;
    b) responsively to the outcome of the parity check, computing flip decisions for the bits of the received word, and
    c) repeating (a) and (b) at least once, wherein in each repetition of (a) the parity check is responsive to the current set of flip decisions,
    **CHARACTERIZED IN THAT**:
    d) step (b) and each repetition thereof comprises setting a respective indicator bit for each bit of the received word (50), such that the setting of the indicator bit indicates whether the corresponding bit of the received word should be flipped; and
    e) each repetition of (a) takes as input the values of the indicator bits in lieu of bit values of the received word (60, 70).

2. The method of claim 1, further comprising, after a final repetition of step (b), updating the received word according to the values of the indicator bits.

3. The method of claim 1, wherein each parity check comprises computing parity sums, each parity sum involves a plurality of bits of the received word, and each bit of the received word that is subject to a parity check is involved in a plurality of parity sums.

**4.** The method of claim 3, wherein:

in the parity check corresponding to the first execution of step (a), each parity sum is obtained by summing bits of the received word and the resulting parity sums are stored; and

in the parity check corresponding to each repetition of step (a), each parity sum is obtained by adding a sum of current indicator bits to one of said stored parity sums from said first execution of step (a).

**5.** The method of claim 1, wherein the first execution of (a) results in a plurality of computed check bits that are stored for later use, and in each repetition of (a), new parity bits are computed from the current indicator bits together with the stored computed check bits.

**6.** A decoder, comprising:

a) a codeword register for storing a received word;

b) means for performing a parity check on bits of the received word by computing parity sums, arranged such that each parity sum relates to a plurality of bits of the received word and each bit of the received word relates to a plurality of parity sums;

c) a summing circuit arranged to compute a total parity sum for each bit of the received word; and

d) a conditional circuit arranged to issue, for each bit of the received word, an indication that the state of said bit should be flipped if the pertinent total parity sum passes a threshold test;

**CHARACTERISED BY**:

e) an indicator register for storing a plurality of indicator bits, each said indicator bit corresponding to a respective bit of the received word, wherein the parity check and the issuance by the conditional circuit of corresponding flip indications is repeated at least once and the indicator register is arranged to be updated for each repetition, said updates being based on a parity check taking values of the indicator bits in lieu of bit values of the received word as input, and f) a logic circuit arranged to flip selected bits of the stored received word, as indicated by the bit values in the indicator register.

**7.** The decoder of claim 6, further comprising a storage register for storing an initial plurality of parity sums, and wherein the means for computing parity sums are arranged to update the parity sums from the contents of the storage register together with current values of the indicator bits.

**Patentansprüche**

**1.** Ein Decodierungsverfahren, umfassend:

a) Ausführen einer Paritätsprüfung (40) auf den Bits eines empfangenen Wortes;

b) entsprechend dem Ergebnis der Paritätsprüfung, Berechnen von Flip-Entscheidungen für die Bits des empfangenen Wortes, und

c) mindestens ein einmaliges Wiederholen von (a) und (b), wobei jede Wiederholung der (a) Paritätsprüfung dem momentanen Satz von Flip-Entscheidungen entspricht,

**DADURCH GEKENNZEICHNET, DASS**:

d) Schritt (b) und jedes Wiederholen dieses Schrittes das Setzen eines entsprechenden Indikator-Bits für jedes Bit des empfangenen Wortes (50) umfasst, wobei das Setzen des Indikator-Bits angibt, ob das entsprechende Bit des empfangenen Wortes geflippt werden soll; und

e) jedes Wiederholen von (a) als Eingabe die Werte der Indikator-Bits an Stelle der Bitwerte des empfangenen Wortes (60, 70) nimmt.

**2.** Das Verfahren nach Anspruch 1, weiterhin umfassend, nach einem letzten Wiederholen von Schritt (b), das Aktualisieren des empfangenen Wortes entsprechend den Werten der Indikator-Bits.

**3.** Das Verfahren nach Anspruch 1, wobei jede Paritätsprüfung das Berechnen von Paritätssummen umfasst, wobei jede Paritätssumme eine Vielzahl von Bits des empfangenen Wortes einbezieht und jedes Bit des empfangenen Wortes, welches Gegenstand einer Paritätsprüfung ist, in einer Vielzahl von Paritätssummen einbezogen ist.

**4.** Das Verfahren nach Anspruch 3, wobei:

In der Paritätsprüfung, welche der ersten Durchführung von Schritt (a) entspricht, jede Paritätssumme durch Summieren der Bits eines empfangenen Wortes erhalten wird und die sich daraus ergebenen Paritätssummen gespeichert werden; und

in der Paritätsprüfung, welche jeder Wiederholung von Schritt (a) entspricht, jede Paritätssumme durch Addieren einer Summe von momentanen Indikator-Bits zu einer der besagten gespeicherten Paritätssummen aus der besagten ersten Durchführung von Schritt (a) erhalten wird.

**5.** Das Verfahren nach Anspruch 1, wobei die erste Durchführung von (a) zu einer Vielzahl von errechneten Prüfbits führt, welche für eine spätere Verwendung gespeichert werden, und bei jeder Wiederholung von (a) neue Paritäts-Bits aus den momentanen Indikator-Bits zusammen mit den gespeicherten errechneten Prüfbits berechnet werden.

**6.** Ein Decodierer; umfassend:

a) Ein Codewort-Verzeichnis zum Speichern eines empfangenen Wortes;

b) Mittel zum Durchführen einer Paritätsprüfung auf Bits des empfangenen Wortes durch Errechnen von Paritätssummen, welche so ausgestaltet sind, dass sich jede Paritätssumme auf eine Vielzahl von Bits des empfangenen Wortes, und jedes Bit des empfangenen Wortes auf eine Vielzahl von Paritätssummen bezieht;

c) eine Summierungsverbindung, welche für das Berechnen einer Gesamtparitätssumme für jedes Bit des empfangenen Wortes ausgestaltet ist; und

d) eine konditionelle Verbindung, welche ausgestaltet ist, um für jedes Bit des empfangenen Wortes zu melden, dass der Status des besagten Bits geflippt werden muss, wenn die entsprechende Gesamtparitätssumme einen Grenzwerttest durchläuft;

**DADURCH GEKENNZEICHNET, DASS**:

e) Ein Indikator-Verzeichnis zum Speichern einer Vielzahl von Indikator-Bits, wobei jedes Indikator-Bit einem entsprechenden Bit des empfangenden Wortes entspricht, wobei die Paritätsprüfung und die Erteilung der entsprechenden Flip-Hinweise durch die konditionelle Verbindung mindestens einmal wiederholt wird und das Indikator-Verzeichnis für jede Wiederholung aktualisierbar ist, wobei die besagten Aktualisierungen auf einer Paritätsprüfung basieren, welche Werte der Indikator-Bits an Stelle von Bitwerten des empfangenen Wortes als Eingabe verwendet, und

f) eine logische Verbindung für das Flippen von ausgewählten Bits des gespeicherten empfangenen Wortes, wie durch die Bitwerte im Indikator-Verzeichnis angegeben, ausgestaltet ist.

**7.** Der Decodierer nach Anspruch 6, weiterhin umfassend ein Speicherverzeichnis zum Speichern einer ursprünglichen Vielzahl von Paritätssummen, und wobei die Mittel für das Errechnen von Paritätssummen ausgestaltet sind, um die Paritätssummen aus den Inhalten des Speicherverzeichnisses zusammen mit den momentanen Werten der Indikator-Bits zu aktualisieren.

## Revendications

**1.** Procédé de décodage, comprenant :

a) la réalisation d'un contrôle de parité (40) sur les bits d'un mot reçu ;

b) en réponse au résultat du contrôle de parité, le calcul de décisions de retournement pour les bits du mot reçu, et

c) la répétition de (a) et (b) au moins une fois, dans lequel dans chaque répétition de (a) le contrôle de parité est sensible au jeu courant de décisions de retournement,

**caractérisé en ce que** :

d) l'étape (b) et chacune de ses répétitions comprend l'établissement d'un bit indicateur respectif pour chaque bit du mot reçu (50), de façon que l'établissement du bit indicateur indique si le bit correspondant du mot reçu doit être retourné ; et

e) chaque répétition de (a) prend comme entrées les valeurs des bits indicateurs au lieu des valeurs binaires du mot reçu (60, 70).

**2.** Procédé selon la revendication 1, comprenant en outre, après une répétition finale de l'étape (b), la mise à jour du mot reçu en fonction des valeurs des bits indicateurs.

**3.** Procédé selon la revendication 1, dans lequel chaque contrôle de parité comprend le calcul de sommes de parité, chaque somme de parité concerne une pluralité des bits du mot reçu, et chaque bit du mot reçu qui est soumis à un contrôle de parité est concerné par une pluralité de sommes de parité.

4.  Procédé selon la revendication 3, dans lequel :

dans le contrôle de parité correspondant à la première exécution de l'étape (a), chaque somme de parité est obtenue en sommant les bits du mot reçu et les sommes de parité résultantes sont stockées ; et
dans le contrôle de parité correspondant à chaque répétition de l'étape (a), chaque somme de parité est obtenue en ajoutant une somme de bits indicateurs courants à l'une desdites sommes de parité stockées à partir de ladite première exécution de l'étape (a).

5.  Procédé selon la revendication 1, dans lequel la première exécution de l'étape

(a) a pour résultat une pluralité de bits de contrôle calculés qui sont stockés pour un usage ultérieur, et dans chaque répétition de (a), de nouveaux bits de parité sont calculés à partir des bits indicateurs courants associés aux bits de contrôle calculés stockés.

6.  Décodeur comprenant :

a) un registre de mot codé destiné à stocker un mot reçu ;
b) des moyens de réalisation d'un contrôle de parité sur les bits du mot reçu en calculant des sommes de parité, agencés de façon que chaque somme de parité concerne une pluralité de bits du mot reçu et chaque bit du mot reçu concerne une pluralité de sommes de parité ;
c) un circuit de sommation agencé pour calculer une somme de parité totale pour chaque bit du mot reçu ; et
d) un circuit conditionnel agencé pour émettre, pour chaque bit du mot reçu, une indication du fait que l'état dudit bit doit être retourné si la somme de parité totale pertinente passe un test de seuil ;
**caractérisé par** :
e) un registre d'indicateur destiné à stocker une pluralité de bits indicateurs, chaque dit bit indicateur correspondant à un bit respectif du mot reçu, dans lequel le contrôle de parité et l'émission par le circuit conditionnel d'indications correspondantes de retournement sont répétés au moins une fois et le registre d'indicateur est agencé pour être mis à jour pour chaque répétition, lesdites mises à jour étant basées sur un contrôle de parité prenant les valeurs des bits indicateurs au lieu des valeurs binaires du mot reçu en entrées, et
f) un circuit logique agencé pour retourner les bits sélectionnés du mot reçu stocké, comme indiqué par les valeurs binaires dans le registre d'indicateur.

7.  Décodeur selon la revendication 6, comprenant en outre un registre de stockage destiné à stocker une pluralité initiale de sommes de parité, et dans lequel les moyens de calcul des sommes de parité sont agencés pour mettre à jour les sommes de parité à partir du contenu du registre de stockage associé aux valeurs courantes des bits indicateurs.

FIG.   1
(PRIOR ART)

*FIG. 2*

```
                                                                        ┌ 30
┌──────────────────────────────────────────────────────────────────┐
│            ASSIGN RECEIVED WORD R=(R₁, ..., Rₙ)                    │
│            TO VARIABLE NODES V=(V₁, ..., Vₙ)                       │
└──────────────────────────────────────────────────────────────────┘
```

$$\text{ASSIGN RECEIVED WORD } R=(R_1, ..., R_n)$$
$$\text{TO VARIABLE NODES } V=(V_1, ..., V_n)$$
30

$$\text{COMPUTE PARTY CHECKS}$$
$$(C_1,..., C_r)^T \leftarrow HV^T$$
40

$$\text{(RE)INITIALIZE AND STORE INITIAL C IN M}$$
$$(V_1,..., V_n) \leftarrow (0,... 0), \; M \leftarrow C, \; t \leftarrow 1$$
50

$$\text{FOR ALL j: IF } \sum_{i=1}^{r} h_{i,j} \, C_i \geq T_j^{(t)} \; : \; V_j \leftarrow V_j + 1 \; (\text{mod } 2)$$
60

$$\text{UPDATE CHECK NODES}$$
$$C \leftarrow (M + HV^T) \text{MOD } 2, \; t \leftarrow t+1$$
70

$$C = (0,..., 0)? \quad \text{YES}$$

NO

$$t > T_{it} ? \quad \text{NO} \quad \text{YES}$$

$$\text{FAILED: DECODED WORD}$$
$$Z \leftarrow R$$
90

$$\text{DECODED WORD}$$
$$Z \leftarrow R + V \; (\text{MOD } 2)$$
80

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KOU.** Low-Density Parity-Check Codes Based On Finite Geometries: A Rediscover And New Results. *IEEE Transactions On Information Theory,* November 2001, vol. 47 (7), 2711-2736